Europäisches Patentamt

(19) European Patent Office

Office européen des brevets

(11) Publication number: **0 023 847**

**B1**

(12) **EUROPEAN PATENT SPECIFICATION**

(45) Date of publication of patent specification: **30.07.86**

(51) Int. Cl.⁴: **G 11 C 11/24**

(21) Application number: **80302700.2**

(22) Date of filing: **07.08.80**

(54) Semiconductor circuit for a dynamic random access memory.

| | |
|---|---|
| (30) Priority: **07.08.79 JP 100893/79** | (73) Proprietor: **NEC CORPORATION**<br>**33-1, Shiba 5-chome, Minato-ku**<br>**Tokyo 108 (JP)** |
| (43) Date of publication of application:<br>**11.02.81 Bulletin 81/06** | |
| | (72) Inventor: **Ishimoto, Shoji**<br>**c/o Nippon Electric Co., Ltd. 33-1, Shiba**<br>**Gochome**<br>**Minato-ku Tokyo (JP)** |
| (45) Publication of the grant of the patent:<br>**30.07.86 Bulletin 86/31** | |
| (84) Designated Contracting States:<br>**DE FR GB** | (74) Representative: **Pears, David Ashley et al**<br>**REDDIE & GROSE 16 Theobalds Road**<br>**London WC1X 8PL (GB)** |
| (58) References cited:<br>**US-A-4 122 549** | |

Courier Press, Leamington Spa, England.

## Description

The present invention relates to a dynamic logic circuit comprising an input node, an output node, a first insulated gate field effect transistor coupled between a first terminal and the output node, and capacitance coupled to the gate of the first transistor to maintain an operative condition of the first transistor.

In general, in an IGFET dynamic logic circuit for a dynamic random access memory it is necessary to hold a node, which is coupled to a capacitor and an IGFET, in a high impedance state, either at "0" level or at "1" level, for a long period of time. However, if there is a leak source at the node, the high impedance node cannot hold the logic information and its level decays gradually. In a dynamic memory of a multi-address system, the circuit is controlled by two external control signals called $\overline{RAS}$ (Row Address Strobe) and $\overline{CAS}$ (Column Address Strobe). If the node of the internal circuit is not refreshed for a long period of time and is not provided with means for holding its level, then the node level will decay gradually. Eventually it becomes impossible to obtain a normal response. A known memory system which is subject to such node level decay is described in United States Patent Specification No. 3,969,706.

United States patent specification 4,122,549 relates to a dynamic RAM in which each memory cell consists of a single insulated gate field effect transistor and a single capacitor, and discloses a voltage regeneration circuit connected to a dataline for maintaining a clearly defined "1" voltage. This known "1" voltage regeneration circuit consists of two MOS transistors and two capacitors respectively connected between the gate electrodes and source electrodes of the transistors. Clock signals are respectively supplied to the drain electrodes in succession when the dataline, which is connected to the gate electrode of the first transistor and the source electrode of the second transistor, the source of the first and the gate of the second being connected together, is at the "1" state. The voltage regeneration is effected by bootstrapping through the two capacitors. The "1" level is set on the dataline by switching another insulated gate field effect transistor into its low impedance state, thereby coupling a supply terminal to the dataline through this other transistor. However, due to the successive application of the clock signals respectively to the drain electrodes of the first and second transistors, the dataline is momentarily switched to the "0" level when the second transistor conducts before a clock signal is applied to its drain.

It is an object of the present invention to provide a circuit which overcomes the above-mentioned problem of level decay in a way which ensures that the maintained logic level is stable throughout operation.

According to one aspect of the invention, the problem is overcome by a dynamic logic circuit as defined at the beginning, characterised by a transfer circuit responsive to a control signal to couple the input node to the output node, and a control circuit responsive to a level at the output node to selectively enable conduction of the first transistor, the control circuit including the said capacitance, circuitry having an input coupled to the output node and generating a delayed non-inverted output signal at a non-inverted output and a delayed inverted output signal at an inverted output, and a second insulated gate field effect transistor, the said capacitance being connected in series with the second transistor between the output node and the non-inverted output of the said circuitry, the second transistor having a gate coupled to the inverted output of the said circuitry, and the gate of the first transistor being connected to one side of the said capacitance, whereby the said operative condition of the first transistor is maintained by the said delayed non-inverted output signal.

The operation of the transfer circuit and the control circuit results in the ouput node being set and maintained at the desired logic level.

The invention will be described in more detail, by way of example, with reference to the accompanying drawings, in which:

Figure 1 is a circuit diagram showing a known semiconductor output circuit for a dynamic RAM,

Figure 2 is a waveform diagram showing various internal waveforms in the known circuit shown in Figure 1;

Figure 3 is a circuit diagram showing a first embodiment of the present invention;

Figure 4 is a waveform diagram various internal waveforms in the circuit shown in Figure 3,

Figure 5 is a circuit diagram showing a second embodiment of the present invention,

Figure 6 is a waveform diagram showing input and output waveforms and internal node waveforms in the circuit shown in Figure 5,

Figure 7 is a circuit diagram of output circuit for a memory employing a multiaddress system including an embodiment of the present invention which is a modification of Figure 5, and

Figure 8 is a waveform diagram showing input and output waveforms and internal node waveforms in the circuit shown in Figure 7.

Among insulated gate field effect transistors, MOS transistors (hereinafter) abbreviated as MOST) are representative and are employed, by way of example throughout the following description. Moreover, the description is given with respect to N-channel MOST's and it is assumed that a high level is a logic "1" level and a low level is a logic "0" level. However, with respect to the circuit structure, the description is essentially the same even if P-channel MOST's are employed.

In a multi-address memory system, the output level is controlled only by $\overline{CAS}$ and it is asynchronous with $\overline{RAS}$. However, since resetting of an internal signal generated by $\overline{CAS}$ is effected in synchronism with $\overline{RAS}$, a transfer gate MOST for isolation is necessitated between an output buffer and an output MOST, which correspond to DATA OUTPUT LATCH & BUFFER in the above-mentioned US Patent Specification No. 3969806.

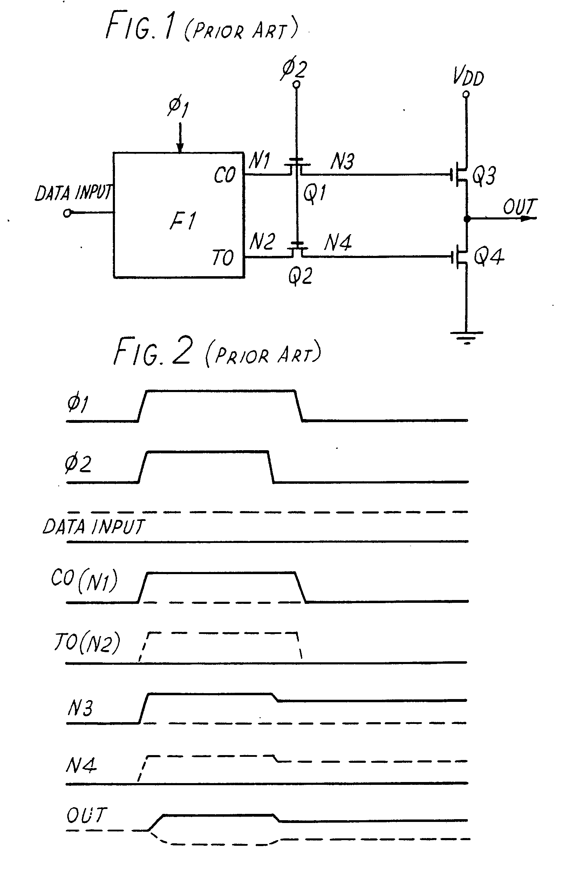

In Figure 1 a logic signal at a point DATA INPUT is latched by a flip-flop F1 in response to an activation signal $\phi_1$ for the flip-flop, and true and complement signals (CO, TO) for the logic signal appear at nodes $N_1$ and $N_2$, respectively. At the same time, in response to a change of a control signal $\phi_2$ from a "0" level to a "1", nodes $N_1$ and $N_3$ and nodes $N_2$ and $N_4$, respectively, are brought into a coupled state via MOST's $Q_1$ and $Q_2$, respectively. The nodes $N_3$ $N_4$ are the gates of most's $Q_3$ and $Q_4$ in series between $V_{DD}$ and ground and hence a level corresponding to the logic signal at the point DATA INPUT appears at an output terminal OUT between $Q_3$ and $Q_4$. In this case, when $\overline{RAS}$ has changed to a reset condition, the internal information (CO, TO) at the nodes $N_1$ and $N_2$ is reset by the signal $\phi_1$ which is controlled $\overline{CAS}$. However, since it is necessary to hold the level at the output terminal OUT unchanged, it is required to provide a time difference between the resettings of the control signals $\phi_1$ and $\phi_2$ so that the logic levels at the nodes $N_3$ and $N_4$ can be retained. In the prior art, the node $N_1$ is isolated from the node $N_3$ and the node $N_2$ is isolated from the node $N_4$ with respect to an impedance by resetting (setting at the "0" level) the control signal $\phi_2$ earlier than the control signal $\phi_1$, and accordingly the node $N_3$ and the node $N_4$ are isolated in a high impedance state to be held at the "0" level and the "1" level respectively, or vice versa. In this circuit, if when the node $N_3$ and the node $N_4$ are left in a high impedance state the levels at these nodes are changed, recovery of the previous states at the nodes is not possible. The principal cause of level changing in the high impedance state is change of the control signal $\phi_2$ from the "1" level to the "0" level, since the levels at the node $N_3$ and at the node $N_4$ are made to fall due to the gate-source capacitances of the MOST's $Q_1$ and $Q_2$, and the magnitude of the voltage fall is determined by the ratio of the gate-source capacitances to the capacitances at the nodes $N_3$ and $N_4$. Moreover, if leakage exists in the MOST's and stray capacitances affect the nodes $N_3$ $N_4$, the high impedance level will be further lowered. In a memory device employing a 5 V power supply, this problem is especially liable to occur, and the aforementioned phenomena are specially noticeable when the output OUT is at the "1" level. This is because, when the level of the node $N_3$ is at the "1" level, the gate of the MOST $Q_3$ is at the power supply $V_{DD}$ level and hence MOST $Q_3$ is operating in a saturation range to produce a level ($V_{DD}$ minus the threshold voltage of the MOST $Q_3$) at its source. Consequently the lowered level at the node $N_3$ cannot drive the output MOST$Q_3$ sufficiently. On the other hand, in the case where the node $N_4$ is at the "1" level and the output OUT is at the "0" level, the MOST $Q_4$ is driven in a triode region where the capability of the output has a margin, and therefore, there occurs no such problem.

All of the described signals are illustrated in Figure 2 using broken and full lines to represent the alternatives of "1" and "0" inputs respectively.

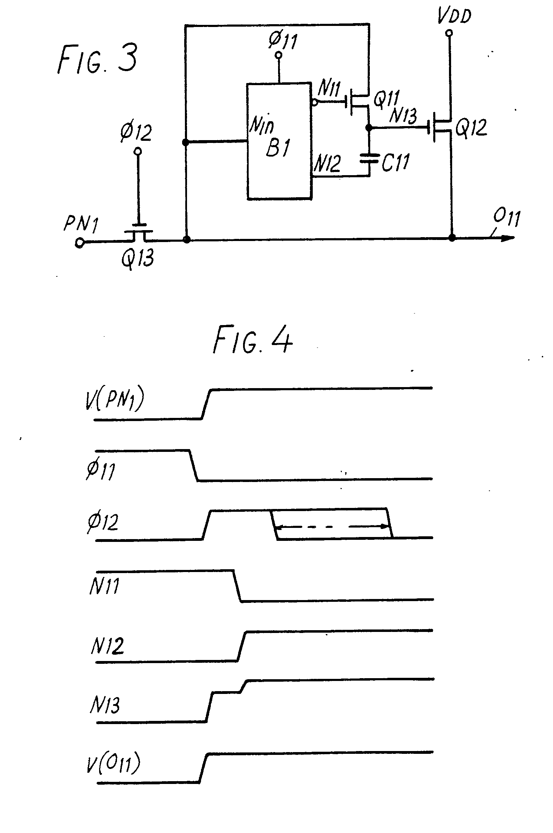

Now a first embodiment according to the present invention will be explained with reference to Figures 3 and 4. A delay circuit B1 has an input $N_{in}$ connected to an output node $O_{11}$ which assumes a high-impedance and a high-level state when the output is "1". The delay circuit has two outputs, namely an output $N_{11}$ which is inverted with respect to the level at the node $O_{11}$, the other being an output $N_{12}$ which is not inverted. The resetting of this delay circuit B1 is effected by a control signal $\phi_{11}$. The node $O_{11}$ is further connected to the drain of a MOST $Q_{11}$, whose gate is connected to the inverted output $N_{11}$ of the delay circuit B1 and whose source is connected to the gate of a second MOST $Q_{12}$ (node $N_{13}$) and to one plate of a capacitor $C_{11}$, the other plate of which is connected to the non-inverted output $N_{12}$. The drain of the MOST $Q_{12}$ is connected to a power supply $V_{DD}$, and its source provides the output node $O_{11}$. The MOST $Q_{12}$ serves to hold the level at the node $O_{11}$ at a high level when the MOST $Q_{12}$ is conductive. The node $O_{11}$ is also coupled to an input point $PN_1$ through a MOST $Q_{13}$ which has a control signal $\phi_{12}$ applied to its gate.

Operation of this circuit will be described with reference to Figure 4. In a reset condition the control signals $\phi_{11}$ and $\phi_{12}$ are respectively at the "1" and "0" level, and the node $O_{11}$ is also at the "0" level as shown by V ($O_{11}$). The node $N_{11}$ is at the "1" level because it is inverted with respect to the node $O_{11}$, and the node $N_{12}$ is at the "0" level, and hence the node $N_{13}$ is at the "0" level. In addition, the input signal V ($PN_1$) at the node $PN_1$ is at the "0" level. Simultaneously with the rise of the input signal V ($PN_1$) in level, the control signals $\phi_{11}$ and $\phi_{12}$ also change from "1" level to the "0" level and from the "0" level to the "1" level, respectively, and thereby the input signal is transmitted to the node $O_{11}$ and the delay circuit B1 starts its delay operation. In this time the node $N_{13}$ is charged up through the MOST $Q_{11}$. Then, after the delay period of the delay circuit B1, the output node $N_{12}$ of the delay circuit B1 changes from the "0" level to the "1" level after completion of charging of the node $N_{13}$ and thereby raises the level at the node $N_{13}$ up to a level higher than the power supply $V_{DD}$, so that the node $O_{11}$ which serves as an output is coupled to the power supply through the MOST $Q_{12}$ in a low impedance condition. Under such a condition, besides the input signal V ($PN_1$), the node $O_{11}$ is provided with a hold circuit with respect to the power supply $V_{DD}$, and hence even in the MOST $Q_{13}$ is turned off by changing the control signal $\phi_{12}$ to the "0" level, the level V ($PN_1$) of the output node $O_{11}$ can be held at the power level ($V_{DD}$).

Although the above description was given for the case where the signal V ($PN_1$) is changed to "1" level, the case where the signal V ($PN_1$)

remains at "0" level can be similarly understood. In this case, the level of the node $N_{11}$ and the level of the node $N_{12}$ remain at "1" and "0" levels, respectively, and hence the level of the node $N_{13}$ is kept at "0" level so that the MOST $Q_{12}$ remains non-conducting. Thus, the "0" level is held on the node $O_{11}$.

The operation of this circuit embodying the present inveniton is characterised by the following advantages:

(1) When the gate control signal $\phi_{12}$ for the MOST $Q_{13}$ has changed from the "1" level to the "0" level, since the node $O_{11}$ is coupled through a low impedance provided by the MOST $Q_{12}$ to the power supply $V_{DD}$, lowering of the level by the gate-source capacitance of the MOST $Q_{13}$ prevented.

(2) Likewise, when the node $O_{11}$ is in a high impedance condition, if any leak source is present, the "1" level will tend to be lowered gradually. However, owing to existence of the MOST $Q_{12}$ the lowering of the level can be prevented.

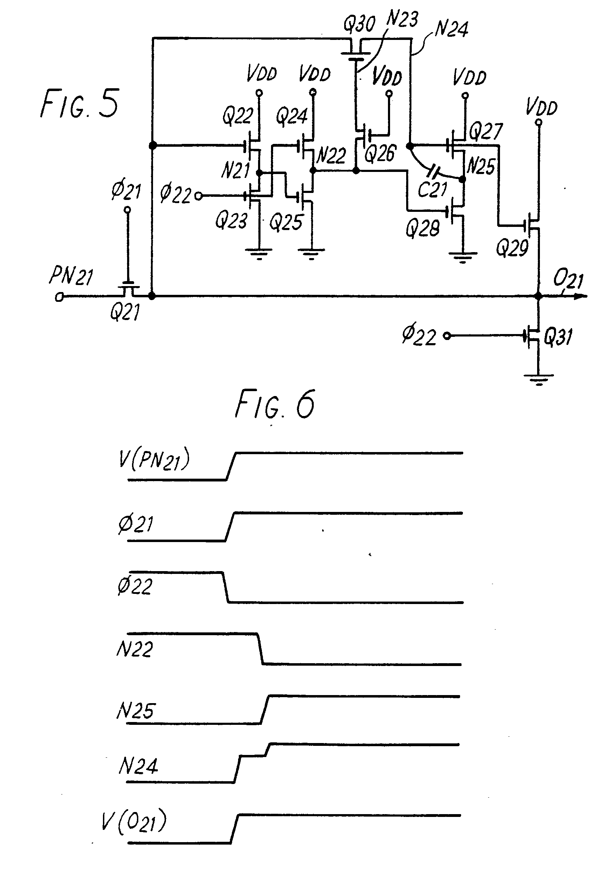

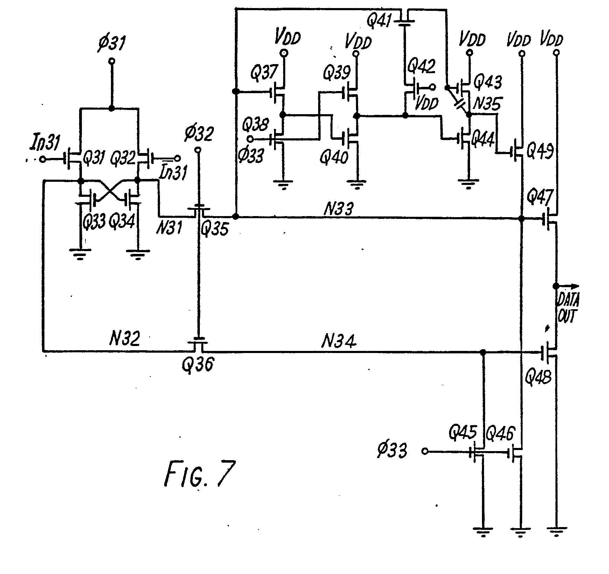

With reference to Figures 5 and 6, another embodiment of the present invention will be described. An input point $PN_{21}$ is coupled to an output node $O_{21}$ through a MOST $Q_{21}$ which has a control signal $\phi_{21}$ applied to its gate, and the aforementioned output node $O_{21}$ is connected to the drain of a transfer MOST $Q_{30}$ which drives a MOST $Q_{29}$ for holding the level of the output node $O_{21}$ in a low impedance condition, and to a gate of a MOST $Q_{22}$ which serves as a trigger for a delay circuit composed of MOST's $Q_{22}$, $Q_{23}$, $Q_{24}$ and $Q_{25}$. Also the output of this delay circuit serves to drive a bootstrap circuit consisting of MOST's $Q_{27}$ and $Q_{28}$ and a bootstrap capacitor $C_{21}$, and simultaneously to turn off The MOST $Q_{30}$ through a MOST $Q_{26}$ after activation of the output node $O_{21}$.

The operation will be described with reference to Figure 6. In the reset conditon, the control signals $\phi_{21}$ and $\phi_{22}$ are at the "0" and "1" levels respectively, the nodes $N_{21}$, $N_{24}$, $N_{25}$ and $O_{21}$ are at the "0" level, and the nodes $N_{22}$ and $N_{23}$ are at the "1" level. In particular, the output node $O_{21}$ is reset to "0" level by a transistor $Q_{31}$ turned on by $\phi_{22}$. In response to the change of the control signal $\phi_{22}$ from the "1" level to the "0" level and the change of the control signal $\phi_{21}$ from the "0" level to the "1" level, the output node $O_{21}$ is coupled to the input point $PN_{21}$ through the MOST $Q_{21}$, and thereafter when the input signal $V (PN_{21})$ at the point $PN_{21}$ changes from the "0" level to the "1" level, the response of this circuit commences. The output node $O_{21}$ is charged up through the MOST $Q_{21}$ and thus takes the "1" level. At the same time the node $N_{24}$ connected to the gates of the MOST's $Q_{27}$ and $Q_{29}$ is charged up through the MOST $Q_{30}$. A node $N_{22}$ forming the output of the delay circuit changes from the "1" level to the "0" level after a predetermined period. Accordingly, the node $N_{25}$ is changed to the "1" level, so that the node $N_{24}$ is raised to a potential higher than the power supply $V_{DD}$ due to the bootstrap effect, and thus the output node $O_{21}$ is held at the power supply level $V_{DD}$ by the MOST $Q_{29}$. After completion of the above-mentioned operation, even when the control signal $\phi_{21}$ changes to the "0" level and the MOST $Q_{21}$ takes the OFF condition, the output node $O_{21}$ will not assume a high impedance condition but is coupled to the power supply under a low impedance condition through the MOST $Q_{29}$.

In Figure 7 is shown a circuit diagram of an output circuit for a memory employing a multi-address system including an embodiment of the present invention which is a modification of the circuit of Figure 5. The circuit is constructed in such manner that it is controlled by two external control signals called $\overline{RAS}$ and $\overline{CAS}$ and, while internal control signals produced by $\overline{RAS}$ and $\overline{CAS}$ are all reset by $\overline{RAS}$, the data output is controlled only by the $\overline{CAS}$. In order to realise such operations, the circuit construction is such that internal control signals $\phi_{31}$ and $\phi_{32}$ and true and complement input signals, $In_{31}$ and $\overline{In_{31}}$ derived from an I/O bus are controlled by both $\overline{CAS}$ and $\overline{RAS}$, but an internal control signal $\phi_{33}$ is controlled only by $\overline{CAS}$.

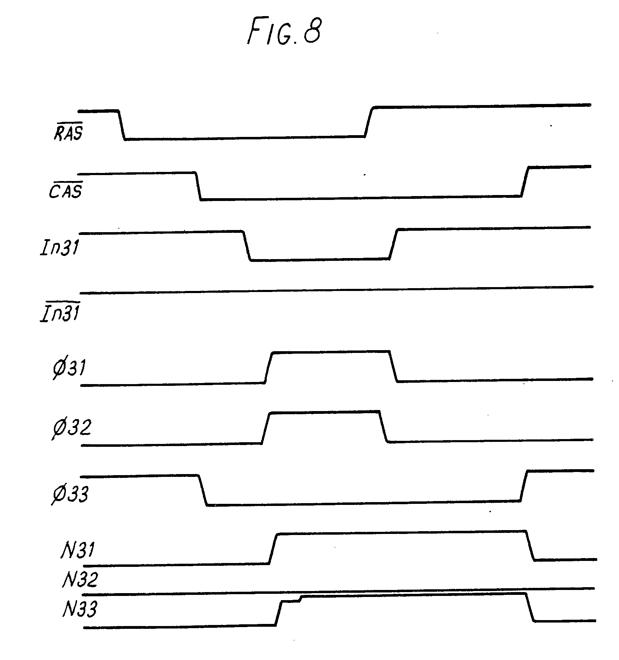

Figure 8 shows the respective input and output waveforms and the voltage waveforms at the respective nodes, and the illustrated example relates to the case where the $\overline{RAS}$ is reset earlier than $\overline{CAS}$. In response to the change of $\overline{RAS}$ from the "1" level which is the reset condition of the $\overline{RAS}$ to the "0" level, the memory is activated so that one word line corresponding to the row address input is selected, signals corresponding to the selected memory cells appear on the respective bit lines, and owing to activation of sense amplifiers, logic levels of either the "0" level or the "1" level can be obtained on the bit lines. Subsequently, in response to the activation of $\overline{CAS}$, a switch between a bit line corresponding to a column address and an I/O bus is turned ON, so that the bit line information appears on the I/O bus and it is amplified by an I/O bus amplifier to the "0" for "1" level. The I/O bus true and complement signals $In_{31}$ and $\overline{In_{31}}$ in Figure 7 correspond to this signal, and activation of the control signals $\phi_{31}$ and $\phi_{32}$ is effected after a difference signal $In_{31}$ and $\overline{In_{31}}$. The activation timings for the control signals $\phi_{31}$ and $\phi_{32}$ are substantially the same timing, and in response to the activation of the control signal $\phi_{32}$, the nodes $N_{31}$ and $N_{32}$ are respectively coupled with a low impedance to the nodes $N_{33}$ and $N_{34}$, respectively, through the MOST's $Q_{35}$ and $Q_{36}$. In response to the activation of the control signal $\phi_{31}$, the levels of the outputs $N_{31}$ and $N_{32}$ of the flip-flop composed of MOST's $Q_{31}$, $Q_{32}$, $Q_{33}$ and $Q_{34}$ are determined so as to correspond to the I/O bus true and complement signals $In_{31}$ and $\overline{In_{31}}$. Assuming now that the I/O bus signal $In_{31}$ is at the "0" level and the other I/O bus signal $\overline{In_{31}}$ is at the "1" level, the node $N_{31}$ takes the "1" level, while the node $N_{32}$ takes the "0" level, and hence through the MOST's $Q_{35}$ and $Q_{36}$ the node $N_{33}$ is changed to the "1" level and the node $N_{34}$ is changed to the "0" level. At the same time, similarly to the above-described embodiment, the MOST $Q_{49}$ is turned ON, and thus holds the node $N_{33}$ at the power supply level $V_{DD}$. Accordingly, during the activation period of $\overline{RAS}$, the "1" level at the node $N_{33}$ can be held by the MOST $Q_{32}$, MOST $Q_{35}$ and MOST $Q_{49}$. When $\overline{RAS}$ is turned to a reset condition, at first the control signal $\phi_{32}$ becomes "0" and thereby isolates the nodes $N_{31}$ and $N_{32}$ from the nodes $N_{33}$ and $N_{34}$, respectively, at the MOST's $Q_{35}$ and $Q_{36}$. At this time, though it might be thought that the level at the node $N_{33}$ would be lowered due to the gate-source capacitance of the MOST $Q_{35}$, the level at the mode $N_{33}$ can be held by the MOST $Q_{49}$ and hence the output level will not be lowered. Thereafter the control signal $\phi_{31}$ is reset, precharge of the I/O bus ($In_{31}$ and $\overline{In_{31}}$) is effected, and thus the circuit takes a stand-by condition. However, the levels at the node $N_{33}$ and at the output DATA OUT are still held by the MOST $Q_{49}$. When the internal control signal $\phi_{33}$ becomes "1" in response to resetting of $\overline{CAS}$, the resetting of the nodes $N_{33}$ and $N_{35}$ and the delay circuit is completed, and the output node DATA OUT takes a high impedance condition.

As described above, by employing the circuit construction according to the present invention at a high impedance node, it is possible to prevent lowering of a high level under a high impedance condition.

**Claims**

1. A dynamic logic circuit comprising

an input node (PN1), an output node (O11), a first insulated gate field effect transistor (Q12) coupled between a first terminal ($V_{DD}$) and the output node (O11), and a capacitance (C11) coupled to the gate of the first transistor (Q12) to maintain an operative condition of the first transistor (Q12), characterised by

a transfer circuit (Q13) responsive to a control signal ($\phi$12) to couple the input node (PN1) to the output node (O11),

and a control circuit responsive to a level at the output node (O11) to selectively enable conduction of the first transistor (Q12), the control circuit including the said capacitance (O11), circuitry (B1) having an input ($N_{in}$) coupled to the output node (O11) and generating a delayed non-inverted output signal at a non-inverted output (N12, N25) and a delayed inverted output signal at an inverted output (N11, N23),

and a second insulated gate field effect transistor (Q11, Q30), the said capacitance (C11, C21) being connected in series with the second transistor (Q11, Q30) between the output node (O11, O21) and the non-inverted output (N12, N25) of the said circuitry (B1), the second transistor (Q11, Q30) having a gate coupled to the inverted output (N11, N23) of the said circuitry (B1), and the gate of the first transistor (Q12, Q29) being connected to one side of the said capacitance, whereby the said operative condition of the first transistor (Q12, Q29) is maintained by the said delayed non-inverted output signal.

2. A dynamic logic circuit according to claim 1, characterised in that the gate of the said first transistor (Q12, Q29) is connected to the junction point of the series connection of the said capacitance (C11, C21) and the said second transistor (Q11, Q30).

3. A dynamic logic circuit according to claim 1, characterised in that the gate of the said first transistor (Q49) is connected to the said non-inverted output (N35) of the said circuitry (B1).

4. A dynamic logic circuit according to claim 1 or 2 or 3, characterised in that the said circuitry (B1) includes a third insulated gate field effect transistor (Q27, Q43) coupled between the said non-inverted output (N25, N35) thereof and the said first terminal ($V_{DD}$) and a fourth insulated gate field effect transistor (Q28, Q44) coupled between the said non-inverting output (N25) thereof and a second terminal, the third transistor (Q27, Q43) having a gate coupled to the junction point of the series connection of the said capacitance (C21) and the said second transistor (Q30, Q41).

5. A dynamic logic circuit according to any preceding claim, characterised by a reset circuit (Q31; Q46) for operatively resetting a level at the output node (O21; N33).

6. A dynamic logic circuit according to any preceding claim, characterised in that the control circuit is such as to enable conduction of the first transistor (Q12; Q29; Q49) when the potential at the output node (O11; O21; N33) reaches a level near to the potential at the first terminal ($V_{DD}$).

**Patentansprüche**

1. Dynamischer Logikschaltkreis mit

einem Eingangsknotenpunkt (PN1), einem Ausgangsknotenpunkt (O11), einem ersten Isolierschicht - Feldeffekttransistor (Q12), der zwischen einem ersten Anschluß ($V_{DD}$) und dem Ausgangsknotenpunkt (O11) gekoppelt ist, und einer Kapazität (C11), die mit dem Tor des ersten Transistors (Q12) verbunden ist, um einen Betriebszustand des ersten Transistors (Q12) aufrechtzuerhalten, gekennzeichnet durch,

einen auf ein Steuersignal ($\phi^s_2$2) ansprechenden Übertragungsschaltkreis (Q13) zum Koppeln des Eingangsknotenpunktes (PN1) mit dem Ausgangsknotenpunkt (O11).

einem auf einen Pegel am Ausgangsknotenpunkt (O11) ansprechenden Steuerschaltkreis zum selektiven Freigeben der Leitung des ersten Transistors (Q12), wobei der Steuerschaltkreis die Kapazität (C11) einschließt, eine Schaltung (B1) mit einem mit dem Ausgangsknotenpunkt (O11) gekoppelten Eingang ($N_{in}$), die bei einem nicht-invertierten Ausgang (N12, N25) ein verzögertes, nicht - invertiertes Ausgangssignal und bei einem invertierten Ausgang (N11, N23) ein verzögertes, invertiertes Ausgangssignal erzeugt,

und einen zweiten Isolierschicht - Feldeffekttransistor (Q11, Q30), wobei die Kapazität (C11, C21) in Serie zwischen dem Ausgangsknotenpunkt (O11, O21) und dem nichtinvertierten Ausgang (N12, N25) der Schaltung (B1) mit dem zweiten Transistor (Q11, Q30) verbunden ist, der zweite Transistor (Q11, Q30) ein mit dem invertierten Ausgang (N11, N23) der Schaltung (B1) gekoppeltes Tor aufweist und das Tor des ersten Transistors (Q12, Q29) mit einer Seite der Kapazität verbunden ist, wodurch der Betriebszustand des ersten Transistors (Q12, Q29) durch das verzögerte, nicht- invertierte Ausgangssignal aufrechterhalten wird.

2. Dynamischer Logikschaltkreis nach Anspruch 1, dadurch gekennzeichnet, daß das Tor des ersten Transistors (Q12, Q29) mit dem Knotenpunkt der Serienschaltung der ersten Kapazität (C11, C21) und des zweiten Transistors (Q11, Q30) verbunden ist.

3. Dynamischer Logikschaltkreis nach Anspruch 1, dadurch gekennzeichnet, daß das Tor des ersten Transistors (Q49) mit dem nicht - invertierten Ausgang (N35) der Schaltung (B1) verbunden ist.

4. Dynamischer Logikschaltkreis nach Anspruch 1, 2 oder 3, dadurch gekennzeichnet, daß die Schaltung (B1) einen zwischen ihren nichtinvertierten Ausgang (N25, N35) und den ersten Anschluß (V_{DD}) gekoppelten dritten Isolierschicht - Feldeffekttransistor (Q27, Q43) und einen zwischen ihren nicht - invertierten Ausgang (N25) und einen zweiten Anschluß gekoppelten vierten Isolier - schicht - Feldeffekttransistor (Q28, Q44) aufweist, wobei de dritte Transistor (Q27, Q43) ein Tor aufweist, das mit dem Knotenpunkt der Serienschaltung der Kapazität (C21) und des zweiten Transistors (Q30, Q41) verbunden ist.

5. Dynamischer Logikschaltkreis nach einem der Ansprüche 1 bis 4, gekennzeichnet durch einen Löschkreis (Q31; Q46) zum Rücksetzen eines Pegels des Ausgangsknotenpunkts (O21; N33).

6. Dynamischer Logikschaltkreis nach einem der Ansprüche 1 bis 5, dadurch gekennzeichnet, daß der Steuerschaltkreis derart ausgebildet ist, daß er den ersten Transistor (Q12; (Q29; Q49) leitend macht, wenn das Potential am Ausgangsknotenpunkt (O11; O21; N33) einen Pegel in de Nähe des Potentials des ersten Anschlusses (V_{DD}) erreicht.

**Revendications**

1. Circuit logique dynamique comprenant:
—un noeud d'entrée (Pn1), un noeud de sortie (O11), un premier transistor à effet de champ à grille isolée (Q12) couplé entre une première borne (V_{DD}) et le noeud de sortie (O11), et un condensateur (C11) couplé à la porte du premier transistor (Q12) pour conserver un état de fonctionnement du premier transistor (Q12), caractérisé par:

—un circuit de transfert (Q13) sensible à un signal de commande (φ12) pour coupler le noeùd d'entrée (Pn1) au noeud de sortie (O11),
—et un circuit de commande sensible à un niveau au noeud de sortie (O11) pour rendre sélectivement conducteur le premier transistor (Q12), le circuit de commande comportant ledit condensateur (O11), un circuit (B1) ayant une entrée (N_{in}) reliée au noeud de sortie (O11), et produisant un signal de sortie non inversé retardé sur une sortie non inversée (N12, N25) et un signal de sortie inversé retardé sur une sortie inversée (N11, N23),
—et un second transistor à effet de champ à grille isolée (Q11, Q30), ledit condensateur (C11, C21) étant connecté en série au second transistor (Q11, Q30), entre le noeud de sortie (O11, O21) et la sortie non inversée (N12, N25) dudit circuit (B1), le second transistor (Q11, Q30) ayant une grille reliée à la sortie inversée (N11, N23) dudit circuit (B1), et la grille du premier transistor (Q12, Q29) étant connectée à un côté dudit condensateur, de sorte que ledit état de fonctionnement du premier transistor (Q12, Q29) est maintenu par ledit signal de sortie non inversé retardé.

2. Circuit logique dynamique selon la revendication, 1, caractérisé en ce que la grille dudit premier transistor (Q12, Q29) est connectée au point de jonction de la connexion en série dudit condensateur (C11, C21) et dudit second transistor (Q11, Q30).

3. Circuit logique dynamique selon la revendication 1, caractérisé en ce que la grille dudit premier transistor (Q49) est connectée à ladite sortie non inversée (N35) dudit circuit (B1).

4. Circuit logique dynamique selon la revendication 1 ou 2 ou 3, caractérisé en ce que ledit circuit (B1) comporte un troisième transistor à effet de champ à grille isolée (Q27, Q43) couplé entre ladite sortie non inversée (N25, N35) de celui-ci et ladite première borne (V_{DD}) et un quatrième transistor à effet de champ à grille isolée (Q28, Q44) couplé ladite sortie non inversée (N25) de celui-ci et une seconde borne, le troisième transistor (Q27, Q43) ayant une grille reliée au point de jonction de la connexion en série dudit condensateur (C21) et dudit second transistor (Q30, Q41).

5. Circuit logique dynamique selon l'une quelconque des revendications précédentes, caractérisé par un premier circuit (Q31; Q46) servant à réinitialiser opération-nellement un niveau au noeud de sortie (O21; N33).

6. Circuit logique dynamique selon l'une quelconque des revendications précédentes, caractérisé en ce que le circuit de commande est tel qu'il rende conducteur le premier transistor (Q12; Q29; Q49) lorsque le potentiel au noeud de sortie (O11; O21; N33) atteint un niveau proche du potentiel de la première borne (V_{DD}).

FIG. 1 (PRIOR ART)

FIG. 2 (PRIOR ART)

FIG. 3

FIG. 4

V(PN₁) → $V(PN_1)$

Ø11 → $\phi_{11}$

Ø12 → $\phi_{12}$

N11 → $\overline{N11}$

N12

N13

V(O₁₁) → $V(O_{11})$

2

*FIG. 5*

*FIG. 6*

FIG. 7

# FIG.8